# EUROPÄISCHE PATENTSCHRIFT

(11) **EP 0 726 512 B1**
(45) Veröffentlichungstag und Bekanntmachung des Hinweises auf die Patenterteilung: **01.12.2004**
(21) Anmeldenummer: 96101613.6
(22) Anmeldetag: 05.02.1996
(51) Int. Cl.: G05F 3/22

(54) **Integrierbare Stromquellenschaltung**
Integratable current source circuit
Circuit source de courant intégrable

(30) Priorität: 09.02.1995 DE 19504289
(43) Veröffentlichungstag der Anmeldung: 14.08.1996
(73) Patentinhaber: Infineon Technologies AG, 81669 München (DE)
(72) Erfinder: Wilhelm, Wilhelm, Dr., D-81477 München (DE)
(74) Vertreter: Epping Hermann & Fischer

(56) Entgegenhaltungen:
- DE-A- 3 115 051
- US-A- 3 930 172
- US-A- 5 233 311
- IEEE JOURNAL OF SOLID-STATE CIRCUITS, vol. 23, no. 3, 1 June 1988, pages 802-815, XP000118522 WASSENAAR R F ET AL: "NEW TECHNIQUES FOR HIGH-FREQUENCY RMS-TO-DC CONVERSION BASED ON A MULTIFUNCTIONAL V-TO-I CONVERTOR"

## Beschreibung

Die Erfindung betrifft eine integrierbare Stromquellenschaltung.

In der Bipolartechnik werden üblicherweise solche Stromquellenschaltungen, die einen positiven Strom an eine auf ein Bezugspotential führende Last abgeben, ausschließlich mit pnp-Transistoren realisiert. Dabei finden die beispielsweise in U.Tietz, Ch.Schenk, Electronic Circuits - Design and Applications, Heidelberg 1991, Seite 57 gezeigten Stromquellenschaltungen Anwendung, wobei anstelle von npn-Transistoren pnp-Transistoren verwendet und die Versorgungspotentiale dementsprechend vertauscht werden. Derartige Stromquellenschaltungen sind meist als Stromspiegel ausgeführt mit einem zu einer Diode verschalteten Transistoreingangszweig und einem durch die daran abfallende Spannung gesteuerten weiteren Transistor im Ausgangszweig. Stromspiegelschaltungen mit pnp-Transistoren werden häufig als aktive Last für Differenzverstärkerstufen oder für Push-Pull-Stufen gebraucht. Die pnp-Transistoren sind in der Regel jedoch deutlich langsamer als npn-Transistoren und verlangen zusätzliche Prozeßschritte bei der Fertigung in integrierter Schaltungstechnik.

In der Literaturstelle Roelof F. Wassenaar et al.: "New Techniques for High-Frequency RMS-to-DC Conversion Based on a Multifunctional V-to-I Convertor", I.E.E.E Journal of Solid-State Circuits 23 (1998) Juni, Nr. 3, New York, NY, USA ist ein V-I-Umsetzer an einer Schaltung mit negativem Widerstand gezeigt (Figuren 8 bis 10). Die Schaltung mit negativem Widerstand enthält zwei an ihren Emittern über einen Widerstand gekoppelte Transistoren, deren Basisanschlüsse kreuzweise an die Kollektoren gekoppelt sind. In den Kollektorzweigen der Transistoren liegen als Dioden geschaltete Bipolartransistoren. An den Emitteranschlüssen der Transistoren liegen jeweilige Stromquellen an. An den Kollektoranschlüssen der als Dioden geschalteten Bipolartransistoren sind Emitterfolgertransistoren angeschlossen.

Aufgabe der Erfindung ist es, eine Stromquellenschaltung anzugeben, die einen gegenüber einem Bezugspotential positiven Ausgangsstrom liefert und keine pnp-Transistoren benötigt.

Die Aufgabe wird gelöst durch eine integrierbare Stromquellenschaltung, umfassend: einen ersten und einen zweiten npn-Transistor, deren Basen jeweils mit dem Kollektor des jeweils anderen Transistors gekoppelt sind, einen ersten Widerstand, der zwischen die Emitter von erstem und zweitem Transistor geschaltet ist, wobei zwischen dem ersten Widerstand und dem Emitter des zweiten Transistors ein Knoten gebildet ist, eine Stromguelle, über die der Knoten an ein Bezugspotential gekoppelt ist, eine Diode, die in Durchlaßrichtung zwischen eine Anschlußklemme und den Kollektor des ersten Transistors geschaltet ist, einen dem ersten Widerstand gleichwertigen zweiten Widerstand, der zwischen die Anschlußklemme und einem gegenüber dem Bezugspotential positiven Versorgungspotential geschaltet,ist, und umfassend die Basis-Emitter-Strecke eines dritten npn-Transistors oder eine weitere Diode, die einerseits mit dem Kollektor des zweiten Transistors gekoppelt sind und andererseits über einen Widerstand an das positive Versorgungspotential gekoppelt sind.

Vorteil der Erfindung ist es, daß mit geringem schaltungstechnischen Aufwand eine Vereinfachung der Fertigung und eine Erhöhung der Grenzfrequenz bei der erfindungsgemäßen Stromquellenschaltung erzielt wird.

In Weiterbildung der Erfindung wird zur Erzeugung des Referenzpotentials ein fünfter Widerstand zwischen Basis und Kollektor des dritten Transistors geschaltet, wobei der fünfte Widerstand von einem Referenzstrom durchflossen wird. Vorteilhafterweise wird durch lediglich einen zusätzlichen Widerstand die Stromquellenschaltung zu einer Stromspiegelschaltung erweitert.

Neben einer nicht differenziellen Ausführungsform sieht die Erfindung auch eine differenzielle Ausführungsform vor, bei der anstelle des dritten Transistors ein weiterer, vierter Widerstand und eine in Reihe dazu geschaltete weitere, zweite Diode in Durchlaßrichtung entsprechend dem ersten Widerstand und der diesen nachfolgenden ersten Diode ersetzt ist. Außerdem ist in die Kollektorleitung des Transistors 2 ein dritter Widerstand geschaltet. Dabei wird der durch zweiten und vierten Widerstand fließende Strom, der an den Knotenpunkt zwischen diesen beiden Widerständen und den jeweils nachfolgenden Dioden über Anschlußklemmen abnehmbar ist, symmetrisch zueinander eingeprägt.

Bei einer Weiterbildung der Erfindung erfolgt die Kopplung der Basen und Kollektoren von erstem und zweiten Transistor miteinander unter Zwischenschaltung jeweils eines Emitterfolgers mit npn-Transistor. Durch diese Maßnahme wird vorteilhafterweise der Spannungsbereich der Stromquellenschaltung erweitert.

Die Erfindung wird nachfolgend anhand der in den Figuren der Zeichnung dargestellten Ausführungsbeispiele näher erläutert. Es zeigt:
- Figur 1: eine nichtdifferenzielle Ausführungsform und
- Figur 2: eine differenzielle Ausführungsform bei einer Anwendung in einem Differenzverstärker.

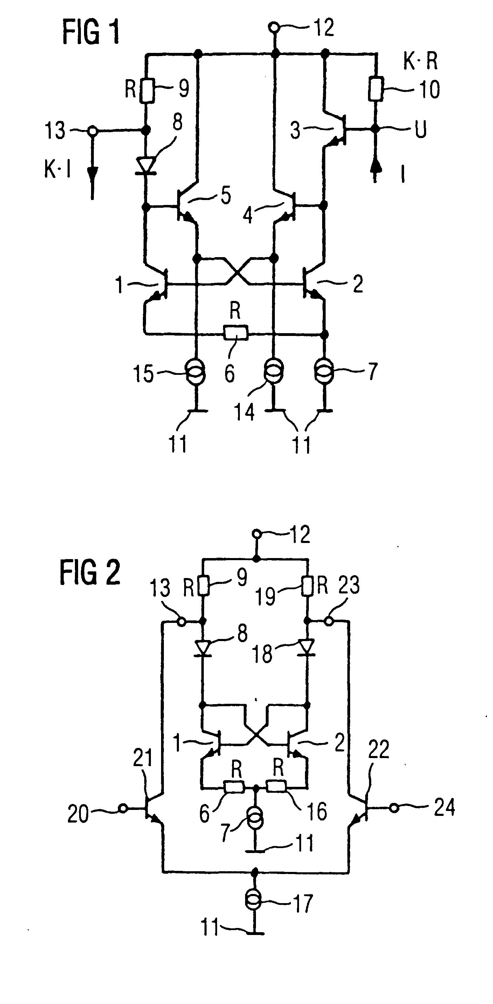

Bei der Ausführungsform nach Figur 1 sind zwei npn-Transistoren 1 und 2 vorgesehen, deren Emitter über einen Widerstand 6 miteinander gekoppelt sind. Der Emitter des Transistors 2 ist zudem über eine Stromquelle 7 an ein Bezugspotential 11 angeschlossen. Der Kollektor des Transistors 1 ist über eine Diode 8 in Durchlaßrichtung mit einer Ausgangsklemme 13 verbunden, die zudem über einen Widerstand 9 an ein positives Versorgungspotential 12 angeschlossen ist. Der Kollektor des Transistors 2 ist mit dem Emitter eines npn-Transistors 3 verbunden, dessen Kollektor an das positive Versorgungspotential 12 und dessen Basis an ein gegenüber dem Bezugspotential 11 positives Referenzpotential U angeschlossen ist. Das Referenzpotential U ist dabei kleiner als das positive Versorgungspotential 12 und wird durch den Spannungsabfall eines zwischen die Basis und den Kollektor des Transistors 3 geschalteten, von einem Strom I durchflossenen Widerstand 10 erzeugt.

Des weiteren ist die Basis des Transistors 1 mit dem Kollektor des Transistors 2 und die Basis des Transistors 2 mit dem Kollektor des Transistors 1 gekoppelt. Neben einer direkten Kopplung der entsprechenden Basen und Kollektoren erfolgt die Kopplung bevorzugt unter Zwischenschaltung von Emitterfolgern, die ihrerseits vorteilhafterweise npn-Transistoren 4 bzw. 5 aufweisen. Dabei sind die Kollektoren der Transistoren 4 und 5 mit dem positiven Versorgungspotential 12 verbunden und ihre Emitter über jeweils eine Stromquelle 14 bzw. 15 an das Bezugspotential 11 angeschlossen. Beim Transistor 5 ist darüber hinaus die Basis mit dem Kollektor des Transistors 1 und der Emitter mit der Basis des Transistors 2 verbunden. In gleicher Weise ist beim Transistor 4 die Basis mit dem Kollektor des Transistors 2 und der Emitter mit der Basis des Transistors 1 verschaltet. Schließlich haben die Widerstände 6 und 9 den selben Widerstandswert R.

Die Funktionsweise der erfindungsgemäßen Stromquellenschaltung beruht darauf, daß die zwischen Basis und Kollektor des Transistors 3 auftretende Spannung gleich der über dem Widerstand 9 abfallenden Spannung ist. Dies ergibt sich daraus, daß die Summe aus der über dem Widerstand 9 abfallenden Spannung und der über der Diode 8 abfallenden Spannung und der an der Basis-Emitter-Strecke des Transistors 1 abfallenden Spannung gleich der Summe ist aus der zwischen Basis und Kollektor des Transistors 3 auftretenden Spannung und der über der Basis-Emitter-Strecke des Transistors 3 abfallenden Spannung und der an der Basis-Emitter-Strecke des Transistors 2 abfallenden Spannung und der an dem Widerstand 6 abfallenden Spannung ist. Aufgrund der Gleichwertigkeit der Widerstände 6 und 9 ergibt sich, daß die Höhe der Spannungsabfälle an beiden Widerständen 6 und 9 im Verhältnis zueinander nur von den sie jeweils durchfließenden Strömen abhängt. Dabei setzt sich der durch den Widerstand 9 fließende Strom aus dem durch den Widerstand 6 fließenden Strom und dem an der Ausgangsklemme 13 entnommenen Strom zusammen. Daraus ergibt sich wiederum, daß der an der Anschlußklemme 13 entnommene Strom multipliziert mit dem Wert R des Widerstandes 9 gleich der Spannung zwischen Basis und Kollektor des Transistors 3 ist.

Wird diese Spannung nun durch einen von einem Strom durchflossenen Widerstand erzeugt, so ergibt sich, daß der in den Widerstand 10 eingespeiste Strom mit dem Wert I multipliziert mit dem Wert k . R des Widerstandes 10 gleich dem Wert des an den Ausgangsklemmen 13 entnommenen Stromes k · I multipliziert mit dem Wert R des Widerstandes 9 ist.

Die erfindungsgemäße Stromquellenschaltung regelt solange als die über dem Widerstand 9 abfallende Spannung nicht größer ist als die Differenz der Basis-Emitter-Spannung des Transistors 3 abzüglich seiner Sättigungsspannung. Dadurch wird bei direkter Kopplung der Transistoren 1 und 2 miteinander der Spannungsbereich der Schaltung eingeschränkt. Zur Erhöhung des Spannungsbereiches finden die beiden Emitterfolger 4, 14 und 5, 15 Verwendung, wobei sich der zulässige Spannungsbereich derart erweitert, daß nunmehr die über dem Widerstand 9 abfallende Spannung nur kleiner sein muß als die Summe aus der Basis-Kollektor-Spannung des Transistors 3 und aus dem Produkt des von der Stromquelle 7 gelieferten Stromes und des Widerstandwertes R.

Bei dem Ausführungsbeispiel nach Figur 2 ist die erfindungsgemäße Stromquellenschaltung differenziell ausgeführt. Dazu ist sie gegenüber der Ausführungsform nach Figur 1 dahingehend abgeändert, daß anstelle des Transistors 3 und des Widerstands 10 ein Widerstand 19 mit dem Widerstandswert R und eine Diode 18 eingesetzt werden. Der Widerstand 19 ist dabei zwischen das positive Versorgungspotential 12 und eine weitere Anschlußklemme 23 geschaltet. Die Diode 18 ist in Durchlaßrichtung zwischen die weitere Anschlußklemme 23 und den Kollektor des Transistors 2 geschaltet. Außerdem ist zwischen Widerstand 6 und Stromquelle 7 einerseits und dem Emitter des Transistors 2 andererseits ein Widerstand 16 mit dem Widerstandswert R eingefügt. Die Basen von Transistor 1 und 2 sind dabei mit dem Kollektor des jeweils anderen Transistors 2 bzw. 1 gegenüber der Ausführungsform nach Figur 1 direkt gekoppelt, d.h., daß die Emitterfolger 4, 14 und 5, 15 entfallen. Sie könnten aber in gleicher Weise auch bei der Ausführungsform nach Figur 2 verwendet werden.

Eine erfindungsgemäße, differenziell ausgeführte Stromquellenschaltung wird gemäß Figur 2 beispielsweise als aktive Last einer Differenzverstärkerstufe verwendet. Die Differenzverstärkerstufe enthält zwei npn-Transistoren 21 und 22, deren miteinander gekoppelte Emitter über eine Stromquelle 17 mit dem Bezugspotential 11 verbunden sind. Als differenzielle Eingänge 20, 24 der Differenzverstärkerstufe sind die Basen der Transistoren 21 und 22 vorgesehen. Die Kollektoren der Transistoren 21 und 22 sind mit den Anschlußklemmen 13 und 23 der differenziellen Stromquellenschaltung verbunden, die die Kollektorströme der Transistoren 21 und 22 symmetrisch einprägt.

Abschließend sei darauf hingewiesen, daß im allgemeinen anstelle der Dioden auch beispielsweise durch Verbinden von Basis und Kollektor zu Dioden verschaltete Transistoren verwendet werden können.

## Patentansprüche

1. Integrierbare Stromquellenschaltung, umfassend:
- einen ersten und einen zweiten npn-Transistor (1, 2), deren Basen jeweils mit dem Kollektor des jeweils anderen Transistors (2, 1) gekoppelt sind,
- einen ersten Widerstand (6), der zwischen die Emitter von erstem und zweitem Transistor (1, 2) geschaltet ist, wobei zwischen dem ersten Widerstand (6) und dem Emitter des zweiten Transistors (2) ein Knoten gebildet ist,
- eine Stromquelle (7), über die der Knoten an ein Bezugspotential (11) gekoppelt ist,
- eine Diode (8), die in Durchlaßrichtung zwischen eine Anschlußklemme (13) und den Kollektor des ersten Transistors (1) geschaltet ist,
- einen dem ersten Widerstand (6) gleichwertigen zweiten Widerstand (9), der zwischen die Anschlußklemme (13) und einem gegenüber dem Bezugspotential (11) positiven Versorgungspotential (12) geschaltet ist, und umfassend
- die Basis-Emitter-Strecke eines dritten npn-Transistors (3) oder eine weitere Diode (18), die einerseits mit dem Kollektor des zweiten Transistors (2) gekoppelt sind und andererseits über einen Widerstand (10, 19) an das positive Versorgungspotential (12) gekoppelt sind.

2. Stromquellenschaltung nach Anspruch 1,
**dadurch gekennzeichnet, daß**
der Kollektor des dritten Transistors (3) mit dem positiven Versorgungspotential (12) verbunden ist und daß zwischen die Basis des dritten npn-Transistors (3) und dem positiven Versorgungspotential (12) ein fünfter Widerstand (10) geschaltet ist, der von einem Referenzstrom (I) durchflossen wird, um ein gegenüber dem positiven Versorgungspotential (12) negatives Referenzpotential (U) zu erzeugen.

3. Stromquellenschaltung nach Anspruch 1,
**dadurch gekennzeichnet, daß**
ein zum erstem Widerstand (6) gleichwertiger dritter Widerstand (16) in Reihe mit dem ersten Widerstand zwischen die Emitter,der ersten und zweiten npn-Transistoren (1, 2) geschaltet ist, und daß die Stromquelle (7) an den Knoten zwischen den ersten und dritten Widerständen (6, 16) angeschlossen ist.

4. Stromquellenschaltung nach Anspruch 1 oder 3,
**dadurch gekennzeichnet, daß**
ein vierter Widerstand (19) zwischen die weitere Diode (18) und das positive Versorgungspotential (12) geschaltet ist, daß an den Knoten zwischen der weiteren Diode (18) und dem vierten Widerstand (19) eine weitere Anschlußklemme (23) angeschlossen ist, daß die weitere Diode (18) in Durchlaßrichtung zwischen die weitere Anschlußklemme (23) und den Kollektor des zweiten npn-Transistors (2) geschaltet ist und daß der vierte Widerstand (19) zum ersten, zweiten und dritten Widerstand (6, 9, 16) gleichwertig ist.

## Claims

1. Integratable current source circuit, comprising:
- a first and a second npn transistor (1, 2), the bases of which are respectively coupled to the collector of the respective other transistor (2, 1),
- a first resistor (6) connected between the emitters of the first and second transistors (1, 2), a node being formed between the first resistor (6) and the emitter of the second transistor (2),
- a current source (7), via which the node is coupled to a reference potential (11),
- a diode (8) connected in the forward direction between a connecting terminal (13) and the collector of the first transistor (1),
- a second resistor (9), which is equivalent to the first resistor (6) and is connected between the connecting terminal (13) and a supply potential (12) that is positive with respect to the reference potential (11), and comprising
- the base-emitter junction of a third npn transistor (3) or a further diode (18), which on the one hand, are coupled to the collector of the second transistor (2) and, on the other hand, are coupled via a resistor (10, 19) to the positive supply potential (12).

2. Current source circuit according to Claim 1,
**characterized in that**
the collector of the third transistor (3) is connected to the positive supply potential (12), and **in that** a fifth resistor (10) is connected between the base of the third npn transistor (3) and the positive supply potential (12), a reference current (I) flowing through the said fifth resistor in order to generate a reference potential (U) that is negative with respect to the positive supply potential (12).

3. Current source circuit according to Claim 1,
**characterized in that**
a third resistor (16) equivalent to the first resistor (6) is connected in series with the first resistor between the emitters of the first and second npn transistors (1, 2) and **in that** the current source (7) is connected to the node between the first and third resistors (6, 16).

4. Current source circuit according to Claim 1 or 3,
**characterized in that**
a fourth resistor (19) is connected between the further diode (18) and the positive supply potential (12), **in that** a further connecting terminal (23) is connected to the node between the further diode (18) and the fourth resistor (19), **in that** the further diode (18) is connected in the forward direction between the further connecting terminal (23) and the collector of the second npn transistor (2), and **in that** the fourth resistor (19) is equivalent to the first, second and third resistors (6, 9, 16).

## Revendications

1. Circuit formant source de courant qui peut être intégré comprenant :
- un premier et un deuxième transistors (1, 2) npn, dont les bases sont couplées, respectivement, au collecteur de l'autre transistor (2, 1 ) ;
- une première résistance (6) qui est montée entre l'émetteur du premier et du deuxième transistors (1, 2), un noeud étant formé entre la première résistance (6) et l'émetteur du deuxième transistor (2) ;
- une source (7) de courant par laquelle le noeud est couplé à un potentiel (11) de référence ;
- une diode (8) qui est montée dans le sens passant entre une borne (13) de connexion et le collecteur du premier transistor (1) ;
- une deuxième résistance (9) de même valeur que la première résistance (6) qui est montée entre la borne (13) de connexion et un potentiel (12) d'alimentation positif par rapport au potentiel (11) de référence et comprenant
- la section de base-émetteur d'un troisième transistor (3) npn ou une autre diode (18), qui sont couplées d'une part au collecteur du deuxième transistor (2) et d'autre part par une résistance (10, 19) au potentiel (12) positif d'alimentation.

2. Circuit formant source de courant suivant la revendication 1, **caractérisé en ce que** le collecteur du troisième transistor (3) est relié au potentiel (12) positif d'alimentation et **en ce qu'**il est monté entre la base du troisième transistor (3) npn et le potentiel (12) positif d'alimentation une cinquième résistance (10) dans laquelle passe un courant (I) de référence pour produire un potentiel(U) de référence négatif par rapport au potentiel (12) positif d'alimentation.

3. Circuit formant source de courant suivant la revendication 1, **caractérisé en ce qu'**une troisième résistance (16) de même valeur que la première résistance (6) est montée en série avec la première résistance entre l'émetteur des premier et deuxième transistors (1, 2) npn et **en ce que** la source (7) de courant est reliée aux noeuds entre les première et troisième résistances (6, 16).

4. Circuit formant source de courant suivant la revendication 1 ou 3, **caractérisé en ce qu'**une quatrième résistance (19) est montée entre la diode (18) supplémentaire et le potentiel (12) positif d'alimentation, **en ce qu'**au noeud entre la diode (18) supplémentaire et la quatrième résistance (19) est reliée une borne (23) de connexion supplémentaire, **en ce que** la diode (18) supplémentaire est montée dans le sens passant entre la borne (23) supplémentaire de connexion et le collecteur du deuxième transistor (2) npn et **en ce que** la quatrième résistance (19) a la même valeur que la première, la deuxième et la troisième résistances (6, 9, 16).
